# EUROPÄISCHE PATENTSCHRIFT

(11) **EP 1 388 166 B1**
(45) Veröffentlichungstag und Bekanntmachung des Hinweises auf die Patenterteilung: **30.03.2005**
(21) Anmeldenummer: 02737947.8
(22) Anmeldetag: 11.04.2002
(51) Int. Cl.: H01L 21/28, H01L 21/321, H01L 29/49

(54) **HERSTELLUNGSVERFAHREN FÜR EIN HALBLEITERBAUELEMENT**
PRODUCTION METHOD FOR A SEMICONDUCTOR COMPONENT
PROCEDE DE REALISATION D'ELEMENT SEMI-CONDUCTEUR

(30) Priorität: 15.05.2001 DE 10123510
(43) Veröffentlichungstag der Anmeldung: 11.02.2004
(73) Patentinhaber: Infineon Technologies AG, 81669 München (DE)
(72) Erfinder: BEWERSDORFF-SARLETTE, Ulrike, 01445 Radebeul (DE); SCHNEEGANS, Manfred, 85591 Vaterstetten (DE); JÄGER, Wolfgang, 85598 Baldham (DE); WEGE, Stephan, 01474 Weissig (DE)
(74) Vertreter: Barth, Stephan Manuel, Dr.
(86) Internationale Anmeldenummer: PCT/EP2002/004065
(87) Internationale Veröffentlichungsnummer: WO 2002/093629

(56) Entgegenhaltungen:
- EP-A- 0 905 753
- EP-A- 0 964 437
- US-A- 5 700 734
- US-B1- 6 221 746

## Beschreibung

Die vorliegende Erfindung betrifft ein Herstellungsverfahren für ein Halbleiterbauelement mit einem Substrat und einem auf dem Substrat angeordneten Elektrodenstapel, welcher eine Polysilizium-Elektrodenschicht und eine darüber liegende wolframhaltige Elektrodenschicht aufweist.

Der Begriff Substrat soll im allgemeinen Sinne verstanden werden und kann daher sowohl einschichtige als auch mehrschichtige Substrate beliebiger Art umfassen.

Obwohl auf beliebige Halbleiterbauelemente anwendbar, werden die vorliegende Erfindung sowie die ihr zu Grunde liegende Problematik in Bezug auf Gateelektrodenstapel dynamischer Schreib-/Lese-Speicher (DRAMs) in Silizium-Technologie erläutert.

In dynamischen Schreib-/Lese-Speichern (DRAMs) werden sogenannte Ein-Transistor-Zellen eingesetzt. Diese bestehen aus einem Speicherkondensator und einem Auswahltransistor (MOS-FET) der die Speicherelektrode mit der Bitleitung verbindet. Der Speicherkondensator kann als Grabenkondensator (Trench Capacitor) oder als Stapelkondensator (Stacked Capacitor) ausgebildet werden.

Zum Ansteuern des Auswahltransistors wird ein metallisch leitender Gateelektrodenstapel auf das Gate-Oxid gesetzt. Typische Gateelektrodenstapel sind Stapel aus dotiertem Polysilizium und einem darüber liegendem Wolframsilizid (WSiₓ) oder einem darüber liegendem Wolframnitrid/Wolfram-Sandwich.

Eine Strukturierung solch eines Gateelektrodenstapels, beispielsweise durch eine Plasma-Ätzung, mittels einer zusätzlichen Siliziumnitrid-Deckschicht auf der oberen wolframhaltigen Elektrodenschicht liefert mit den entsprechenden Gate-Kontakten die metallischen Anschlussleitungen.

Die strukturierten Gateelektrodenstapel werden üblicherweise thermisch derart nachbehandelt, dass gleichzeitig die freigelegten Seitenwände dünn aufoxidiert und der Widerstand im Metall durch gezielte Phasenumwandlung oder Kornwachstum minimiert werden. Die derart gebildete Oxidschicht auf den Seitenwänden des Polysiliziums verbessert das Leckstromverhalten des Transistors und wirkt als Spacer für die nachfolgende LDD (Lightly Doped Drain)-Implantation. Letztere stellt über die definierte Gate-Länge die Transistorparameter ein. Die metallische Phasenumwandlung bei typischen Temperaturen von 1000 bis 1080°C führt zur Widerstandsreduzierung und ist mit starkem Kornwachstum im Gate-Metall verbunden.

Beim derzeitigen Prozess findet das Tempern zwischen 1000 und 1080°C nach der Strukturierung des Gateelektrodenstapels unmittelbar vor der LDD-Implantation statt. Dieser bekannte Prozeß führt zu den folgenden Problemen.

Bei Verwendung von Wolframsilizid (WSiₓ) kommt es unter Einlegieren des darunter liegenden Polysiliziums zum seitlichen Herauswachsen von Körnern über die glattgeätzten Seitenflächen des Gateelektrodenstapels. Diese seitlichen Überstände können insbesondere in zukünftigen Technologien von < 170 nm Strukturgröße zu Kurzschlüssen mit benachbarten Metallkontakten führen, da sie bei der Kontaktätzung aufgeätzt werden können. Aus Dokument US-B1-6 221 746 ist ein Verfahren bekannt, das einen Elektrodenstapel mit einer Polysiliziumschicht, einer Wolfram-haltigen Schicht und Seitwandoxyol herstellt.

DRAM-Technologien mit Transistor-Gate-Längen von weniger als 110 nm erfordern geänderte Zellarchitekturen mit niedrigeren Widerständen und kurzschlussfreien Anschlüssen.

Der Einsatz von Wolfram ohne Si-Legierung mit einer Wolframnitrid-Diffusionsbarriere zum darunter liegenden Polysilizium erfüllt die Widerstandsanforderungen. Wolfram als Gate-Metall ist jedoch derzeit noch nicht prozesstauglich, da es in der weiteren Prozessierung bei Temperatur- und Oxidationsprozessen als WOₓ ausgast bzw. sublimiert und sich an den Kammerinnenwänden niederschlägt, was die Seitenwandoxidation unkontrollierbar macht.

Es ist die Aufgabe der vorliegenden Erfindung, ein verbessertes Herstellungsverfahren für ein Halbleiterbauelement der eingangs genannten Art anzugeben, wobei das Herauswachsen der WSiₓ-Körner bzw. die Sublimation von WOₓ verhindert werden kann.

Erfindungsgemäß wird diese Aufgabe durch das in Anspruch 1 angegebene Herstellungsverfahren gelöst.

Die der vorliegenden Erfindung zugrundeliegende allgemeine Idee besteht darin, dass die thermische Nachbehandlung des Gateelektrodenstapels (Phasenumwandlung bzw. Kornwachstum zur Widerstandsreduzierung) von der Nachbehandlung des Polysiliziums (Seitenwandoxidation) in zwei eigene unabhängige Prozessschritte getrennt wird.

Alle bekannten Abscheide- und Ätzprozesse können dabei identisch erhalten bleiben. Alle nachfolgenden thermischen Prozesse können bei geringerer Temperatur als bisher ablaufen, da die Temperung des Gate-Metalls abgeschlossen ist, was eine Schonung des thermischen Budgets mit sich bringt.

Besondere Vorteile des Temperns bei einer Kombination Wolframnitrid/Wolfram ergeben sich durch eine geringere erforderliche Stapelhöhe zur Erzielung des gleichen Widerstandswerts. Dies schafft ein entspannteres Aspektverhältnis beim Aufbringen der Isolationsschicht und vereinfacht anschließende Ätzprozesse.

In den Unteransprüchen finden sich vorteilhafte Weiterbildungen und Verbesserungen des Gegenstandes der Erfindung.

Gemäß einer bevorzugten Weiterbildung findet ein Kornwachstum und/oder eine Phasenumwandlung verbunden mit einer Widerstandsreduzierung in der Vorläuferschicht bei der ersten Temperatur statt.

Gemäß einer weiteren bevorzugten Weiterbildung besteht die wolframhaltige Vorläuferschicht aus Wolframsilizid, wobei die erste Temperatur im Bereich von 900 bis 1080 °C liegt.

Gemäß einer weiteren bevorzugten Weiterbildung besteht die wolframhaltige Vorläuferschicht aus Wolframmetall, wobei die erste Temperatur im Bereich von 900 bis 1080 °C liegt.

Gemäß einer weiteren bevorzugten Weiterbildung wird unter der wolframhaltigen Vorläuferschicht aus Wolframmetall eine Diffusionsbarrierenschicht aus Wolframnitrid beim Abscheiden der Schichtenfolge vorgesehen.

Gemäß einer weiteren bevorzugten Weiterbildung wird die Schutzschicht mittels eines lithographischen Prozesses zu einer Hartmaske ausgebildet und mit dieser Hartmaske das Strukturieren der Schichtenfolge mittels eines Ätzprozesses durchgeführt.

Gemäß einer weiteren bevorzugten Weiterbildung liegt die zweite Temperatur im Bereich von 800 bis 850 °C.

Gemäß einer weiteren bevorzugten Weiterbildung ist der Elektrodenstapel ein Gate-Elektrodenstapel ist, der auf einer Gateoxidschicht des Substrats liegt.

Ein Ausführungsbeispiel der Erfindung ist in den Zeichnungen dargestellt und in der nachfolgenden Beschreibung näher erläutert.
- Fig. 1a-e: zeigen die zum Verständnis der Erfindung wesentlichen Schritte eines Ausführungsbeispiels des erfindungsgemäßen Herstellungsverfahrens; und
- Fig. 2: zeigt ein weiteres Ausführungsbeispiel des erfindungsgemäßen Herstellungsverfahrens.

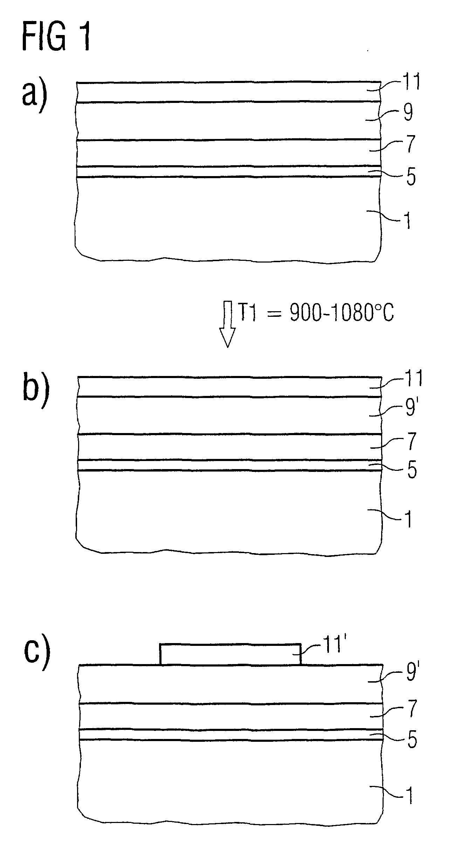

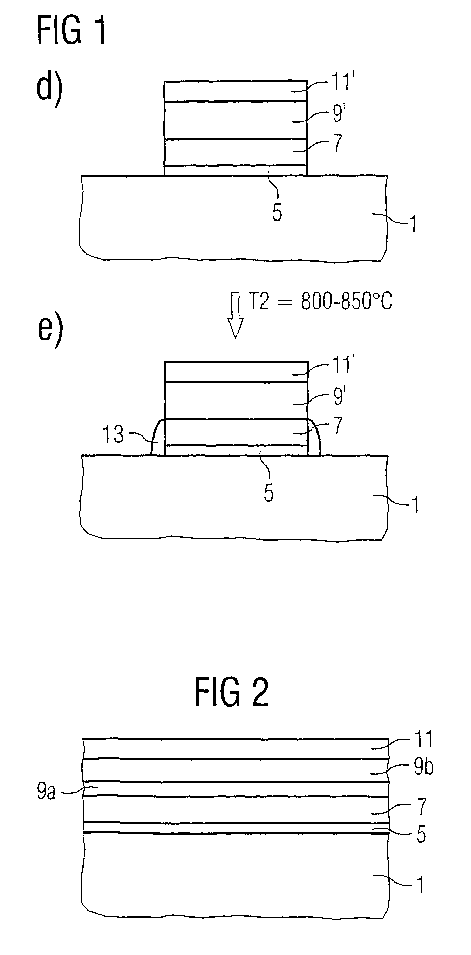

In den Figuren 1a-e bezeichnen gleiche Bezugszeichen gleiche oder funktionsgleiche Elemente.

Gemäß Figur 1a wird zunächst ein Substrat 1 bereit gestellt, welches (nicht gezeigte) aktive Gebiete, wie z.B Source-Gebiete und Drain-Gebiete, aufweist. Auf dem Substrat 1 wird zunächst eine Gateoxidschicht 5 durch einen üblichen thermischen Oxidationsprozess gebildet. Auf der Gateoxidschicht 5 wird eine dotierte Polysiliziumschicht 7 beispielsweise mittels des CVD(Chemical Vapour Deposition) - Verfahrens abgeschieden. Auf der Polysiliziumschicht 7 wird durch ein CVD-Verfahren eine Wolframsilizidschicht 9 abgeschieden.

Bei einem weiteren Ausfführungsbeispiel gemäß Fig. 2 wird eine Wolframnitridschicht 9a und anschließend in der gleichen Prozeßkammer eine Wolframschicht 9b abgeschieden.

Schließlich wird ebenfalls durch ein CVD-Verfahren eine Siliziumnitridschicht 11 abgeschieden. Ab hier sind die Prozeßschritte wieder für beide Ausführungsbeispiele gleich.

Im folgenden Verfahrensschritt, welcher in Figur 1b illustriert ist, erfolgt ein erster Temperschritt bei einer ersten Temperatur Tl im Bereich von 900 bis 1080°C, vorzugsweise 1000 °C. Bei diesem ersten Temperschritt erfolgt eine Phasenumwandlung verbunden mit einem Kornwachstum und einer Widerstandsreduzierung der Wolframsilizidschicht 9, was diese Vorläuferschicht in die endgültige Elektrodenschicht 9' umwandelt.

Mit anderen Worten wird der erste Temperaturschritt (900 bis 1080°C) zur Phasenumwandlung, Kornwachstum oder Widerstandsreduzierung nach vollständiger Abscheidung der Schichten Polysilizium, Gate-Metall, Siliziumnitrid durchgeführt, also mit einer Abdeckschicht oberhalb des Gate-Metalls und vor einer Strukturierung der Gateelektrodenstapel. Durch die Abdeckschicht kann die Sublimation von Wolframoxid (WOₓ) verhindert werden. Darüber hinaus wird die bei der Phasenumwandlung unvermeidliche Bildung von Oberflächenrauhigkeiten (Cavities durch Kornwachstum) und die darüber liegende Nitridschicht verhindert. Somit ist insbesondere kein Siliziumnitrid in den Cavities vorhanden, das bei einer späteren Gatestapelätzung in den Cavities maskierend wirken würde und somit zu Kurzschlüssen führen würde.

Im nächsten Verfahrensschritt wird mittels eines üblichen photolithographischen Schritts die Siliziumnitridschicht 11 zu einer Hartmaske 11' strukturiert, was zum in Figur 1c gezeigten Zustand führt.

Diese Hartmaske 11' wird nun dazu verwendet, um durch einen üblichen Plasma-RIE-Ätzschritt aus der Schichtenfolge der Schichten 5, 7, 9' den Gateelektrodenstapel zu bilden. Dies ist in Figur 1d illustriert. Im Anschluss daran erfolgt in einem Oxidationsofen oder mittels eines schnellen thermischen Oxidationsverfahrens eine Oxidation der verbleibenden Polysiliziumschicht 7, um Seitenwandoxidspacer 13 zu bilden. Dies führt zu dem in Figur le gezeigten Zustand.

Der zweite Temperaturschritt erfolgt bei wesentlich geringeren Temperaturen von 800 bis 850°C nach der Strukturierung des Gate-Stapels zur gezielten Seitenwand-Oxidation der Polysilizium-Oberflächen. Beim Wolframsilizid (WSiₓ) kommt es somit nicht zum seitlichen Herauswachsen der Metallkörner, und die Geometrie der Struktur bleibt erhalten, denn nach der Gatestapelätzung ist der Prozess des Korngrößenwachstums bzw. der Phasenumwandlung im Gatemetall bereits abgeschlossen.

Die anschließenden Prozessschritte sind dem Stand der Technik wohl bekannt und bedürfen hier keiner weiteren Erläuterung. Insbesondere wird in einem folgenden Prozessschritt die besagte LDD-Implantation durchgeführt.

Insbesondere ist die Erfindung auf beliebige Bauelemente anwendbar und nicht auf Gateelektrodenstapel begrenzt.

### Bezugszeichenliste

- 1: Substrat
- 5: Gateoxidschicht
- 7: Polysiliziumschicht
- 9, 9': Wolframsilizidschicht
- 11: Siliziumnitridschicht
- 13: Seitenwand-Siliziumdioxidspacer
- 9a: Wolframnitridschicht
- 9b: Wolframmetallschicht

## Patentansprüche

1. Verfahren zum Herstellen eines Halbleiterbauelements mit einem Substrat (1) und einem auf dem Substrat (1) angeordneten Elektrodenstapel (7, 9', 11', 13), welcher eine Polysilizium-Elektrodenschicht (7) und eine darüberliegende wolframhaltige Elektrodenschicht (9') aufweist, mit den Schritten:
Bereitstellen des Substrats (1);
Abscheiden einer Schichtenfolge mit der Polysiliziumschicht (7), einer darüber liegenden wolframhaltigen Vorläuferschicht (9) und einer darüber liegenden Schutzschicht (11);
Tempern der Schichtenfolge bei einer ersten Temperatur (T1), bei der eine kristalline Umwandlung in der wolframhaltigen Vorläuferschicht (9) stattfindet, so daß daraus die wolframhaltige Elektrodenschicht (9') gebildet wird;
Strukturieren der Schichtenfolge zum Elektrodenstapel (7, 9', 11'); und
Bildung von Seitenwandspacern (13) durch Oxidieren der Polysiliziumschicht (7) bei einer zweiten Temperatur (T2), wobei die zweite Temperatur (T2) derart niedriger als die erste Temperatur (T1) gewählt ist, daß keine kristalline Umwandlung in der wolframhaltigen Elektrodenschicht (9') stattfindet.

2. Verfahren nach Anspruch 1,
**dadurch gekennzeichnet,**
**daß** ein Kornwachstum und/oder eine Phasenumwandlung verbunden mit einer Widerstandsreduzierung in der Vorläuferschicht (9) bei der ersten Temperatur (T1) stattfindet.

3. Verfahren nach Anspruch 1 oder 2,
**dadurch gekennzeichnet,**
**daß** die wolframhaltige Vorläuferschicht (9) aus Wolframsilizid besteht und die erste Temperatur (T1) im Bereich von 900 bis 1080 °C liegt.

4. Verfahren nach Anspruch 1 oder 2,
**dadurch gekennzeichnet,**
**daß** die wolframhaltige Vorläuferschicht (9) aus Wolframmetall (9b) besteht und die erste Temperatur (T1) im Bereich von 900 bis 1080 °C liegt.

5. Verfahren nach Anspruch 4,
**dadurch gekennzeichnet,**
**daß** unter der wolframhaltigen Vorläuferschicht (9) aus Wolframmetall eine Diffusionsbarrierenschicht aus Wolframnitrid (9a) beim Abscheiden der Schichtenfolge vorgesehen wird.

6. Verfahren nach einem der vorhergehenden Ansprüche,
**dadurch gekennzeichnet,**
**daß** die Schutzschicht (11) mittels eines lithographischen Prozesses zu einer Hartmaske (11') ausgebildet wird und mit dieser Hartmaske das Strukturieren der Schichtenfolge mittels eines Ätzprozesses durchgeführt wird.

7. Verfahren nach einem der vorhergehenden Ansprüche,
**dadurch gekennzeichnet,**
**daß** die zweite Temperatur (T2) im Bereich von 800 bis 850 °C liegt.

8. Verfahren nach einem der vorhergehenden Ansprüche,
**dadurch gekennzeichnet,**
**daß** der Elektrodenstapel (7, 9', 11', 13) ein Gate-Elektrodenstapel ist, der auf einer Gateoxidschicht (5) des Substrats liegt.

## Claims

1. Method for fabricating a semiconductor component having a substrate (1) and an electrode stack (7, 9', 11', 13) which is arranged on the substrate (1) and includes a polysilicon electrode layer (7) and a tungsten-containing electrode layer (9') above it, comprising the steps of:
providing the substrate (1);
depositing a layer sequence comprising the polysilicon layer (7), a tungsten-containing precursor layer (9) above it and a protective layer (11) above that;
conditioning the layer sequence at a first temperature (T1) at which a crystalline transformation takes place in the tungsten-containing precursor layer (9), so that the tungsten-containing electrode layer (9') is formed therefrom;
patterning the layer sequence to form the electrode stack (7, 9', 11'); and
forming side wall spacers (13) by oxidizing the polysilicon layer (7) at a second temperature (T2), the second temperature (T2) being selected to be lower than the first temperature (T1) such that no crystalline transformation takes place in the tungsten-containing electrode layer (9').

2. Method according to Claim 1, **characterized in that** a grain growth and/or phase transformation associated with a reduction in resistance takes place in the precursor layer (9) at the first temperature (T1).

3. Method according to Claim 1 or 2, **characterized in that** the tungsten-containing precursor layer (9) consists of tungsten silicide, and the first temperature (T1) is in the range from 900 to 1080°C.

4. Method according to Claim 1 or 2, **characterized in that** the tungsten-containing precursor layer (9) consists of tungsten metal (9b), and the first temperature (T1) is in the range from 900 to 1080°C.

5. Method according to Claim 4, **characterized in that** a diffusion barrier layer made from tungsten nitride (9a) is provided beneath the tungsten-containing precursor layer (9) made from tungsten metal during the deposition of the layer sequence.

6. Method according to one of the preceding claims, **characterized in that** the protective layer (11) is formed into a hard mask (11') by means of a lithography process, and the layer sequence is patterned by means of an etching process using this hard mask.

7. Method according to one of the preceding claims, **characterized in that** the second temperature (T2) is in the range from 800 to 850°C.

8. Method according to one of the preceding claims, **characterized in that** the electrode stack (7, 9', 11', 13) is a gate electrode stack which rests on a gate oxide layer (5) of the substrate.

## Revendications

1. Procédé de fabrication d'un composant semiconducteur avec un substrat (1) et, disposée sur le substrat (1), une pile d'électrodes (7, 9', 11', 13) comportant une couche d'électrode en polysilicium (7), et une couche d'électrode (9') à teneur en tungstène située au-dessus, comprenant les étapes consistant à :
mettre à disposition du substrat (1) ;
appliquer d'une succession de couches avec la couche en polysilicium (7), une couche préliminaire (9) à teneur en tungstène située au-dessus, et une couche de protection (11) située au-dessus ;
tremper la succession de couches à une première température (T1), à laquelle une transformation cristalline a lieu dans la couche préliminaire (9) à teneur en tungstène, ce qui conduit à la formation de la couche d'électrode (9') à teneur en tungstène ;
structurer de la succession de couches en la pile d'électrodes (7, 9', 11') ; et
former des écarteurs de parois latérales (13) par oxydation de la couche en polysilicium (7) à une deuxième température (T2), la deuxième température (T2) étant choisie à un niveau plus faible que la première température (T1) de telle sorte qu'une transformation cristalline n'ait pas lieu dans la couche d'électrode (9') à teneur en tungstène.

2. Procédé selon la revendication 1,
**caractérisé en ce que**
une croissance de grains et/ou une transition de phase associées à une réduction de résistance a lieu dans la couche préliminaire (9) à la première température (T1).

3. Procédé selon la revendication 1 ou 2,
**caractérisé en ce que**
la couche préliminaire (9) à teneur en tungstène est constituée de siliciure de tungstène, et **en ce que** la première température (T1) se situe dans la plage de 900 à 1 080 °C.

4. Procédé selon la revendication 1 ou 2,
**caractérisé en ce que**
la couche préliminaire (9) à teneur en tungstène est constituée de métal de tungstène (9b), et **en ce que** la première température (T1) se situe dans la plage de 900 à 1 080 °C.

5. Procédé selon la revendication 4,
**caractérisé en ce que**,
lors de l'application de la succession de couches, une couche de barrière de diffusion en nitrure de tungstène (9a) est prévue sous la couche préliminaire (9) en tungstène métal à teneur en tungstène.

6. Procédé selon l'une quelconque des revendications précédentes,
**caractérisé en ce que**
la couche de protection (11) est transformée en un masque dur (11') au moyen d'un processus lithographique, et **en ce que** la structuration de la succession de couches est effectuée avec ce masque dur au moyen d'un processus de gravure.

7. Procédé selon l'une quelconque des revendications précédentes,
**caractérisé en ce que**
la deuxième température (T2) se situe dans la plage de 800 à 850 °C.

8. Procédé selon l'une quelconque des revendications précédentes,
**caractérisé en ce que**
la pile d'électrodes (7, 9', 11', 13) est une pile d'électrodes de grille qui est située sur une couche d'oxydation de grille (5) du substrat.
